# EUROPEAN PATENT APPLICATION

(11) **EP 3 618 273 A1**
(43) Date of publication of application: **04.03.2020**
(21) Application number: 17913665.0
(22) Date of filing: 16.06.2017
(51) Int. Cl.: H03F 3/45, H03F 3/189

(54) **HIGH FREQUENCY AMPLIFIER**

(71) Applicant: Mitsubishi Electric Corporation, Chiyoda-ku Tokyo 100-8310 (JP)
(72) Inventor: KAWASAKI, Kengo, Tokyo 100-8310 (JP); TSURU, Masaomi, Tokyo 100-8310 (JP); SHIMOZAWA, Mitsuhiro, Tokyo 100-8310 (JP)
(74) Representative: Pfenning, Meinig & Partner mbB
(86) International application number: PCT/JP2017/022359
(87) International publication number: WO 2018/229977

(57) **Abstract**

There is provided a polyphase filter (5) that generates first differential signals from first signals amplified by a first transistor (2-1), outputs the first differential signals from a first output terminal (5-1) and a third output terminal (5-3), generates second differential signals from second signals amplified by a second transistor (2-2), and outputs the second differential signals from the first output terminal (5-1) and the third output terminal (5-3).

## Description

### TECHNICAL FIELD

The present invention relates to a high frequency amplifier that amplifies first and second signals that are differential signals.

### BACKGROUND ART

Non-Patent Literature 1 set out below discloses a high frequency amplifier that amplifies differential signals using a differential amplifier.

Since a power supply is virtually short-circuited, the differential signals amplified by the differential amplifier are not fed back to the differential input terminal of the differential amplifier via the power supply.

### CITATION LIST

### NON-PATENT LITERATURES

Non-Patent Literature 1: M. Lu, T. B. Kumar, D. Zhang, X. Yu, and K. S. Yeo, "A Wide Band Digital Variable Gain Amplifier with DC Offset Cancellation in SiGe 0.18um BiCMOS Technology", 2016 International Symposium on Integrated Circuits (ISIC)

### SUMMARY OF INVENTION

### TECHNICAL PROBLEM

When a differential amplifier, which is a conventional high frequency amplifier, amplifies differential signals, in-phase signals such as noise may be superimposed on the differential input terminal of the differential amplifier. Since a power supply is not virtually short-circuited, the in-phase signals may be fed back to the differential input terminal of the differential amplifier via the power supply. There has been a problem that, since the in-phase signals may be fed back to the differential input terminal of the differential amplifier via the power supply, a circuit in which a high frequency amplifier is mounted may oscillate.

The present invention has been conceived to solve the problems as described above, and it is an object of the present invention to obtain a high frequency amplifier capable of suppressing output of in-phase signals.

### SOLUTION TO PROBLEM

A high frequency amplifier according to the present invention includes a first transistor for amplifying a first signal, a second transistor for amplifying a second signal that is a differential signal with respect to the first signal, a polyphase filter that includes a first input terminal connected to an output terminal of the first transistor, a second input terminal connected to an output terminal of the second transistor, and first to fourth output terminals, generates a first differential signal from the first signal amplified by the first transistor and outputs the first differential signal from the first and third output terminals, and generates a second differential signal from the second signal amplified by the second transistor and outputs the second differential signal from the first and third output terminals, a plurality of loads having one end connected to each of the first and third output terminals of the polyphase filter and the other end connected to a power supply, and a plurality of amplifier output terminals connected to each of the first and third output terminals of the polyphase filter.

### ADVANTAGEOUS EFFECTS OF INVENTION

According to the present invention, there is provided a polyphase filter that generates the first differential signal from the first signal amplified by the first transistor, outputs the first differential signal from the first and third output terminals, generates the second differential signal from the second signal amplified by the second transistor, and outputs the second differential signal from the first and third output terminals, whereby output of in-phase signals can be suppressed.

### BRIEF DESCRIPTION OF DRAWINGS

FIG. 1 is a configuration diagram illustrating a high frequency amplifier according to a first embodiment of the present invention;
FIG. 2A is an explanatory diagram illustrating a phase at each terminal in the case where signals input by a polyphase filter 5 are differential signals;
FIG. 2B is an explanatory diagram illustrating a phase at each terminal in the case where signals input by the polyphase filter 5 are in-phase signals;
FIG. 3 is an explanatory diagram illustrating an internal circuit in the case where the polyphase filter 5 is an open input type;
FIG. 3B is an explanatory diagram illustrating an internal circuit in the case where the polyphase filter 5 is an input short circuit type;
FIG. 4 is a configuration diagram illustrating another high frequency amplifier according to the first embodiment of the present invention;
FIG. 5 is a configuration diagram illustrating still another high frequency amplifier according to the first embodiment of the present invention;
FIG. 6 is a configuration diagram illustrating a high frequency amplifier according to a second embodiment of the present invention;
FIG. 7 is a configuration diagram illustrating a connection form of first to fourth inductive elements 31 to 34 in a polyphase filter 5;
FIG. 8 is a configuration diagram illustrating a high frequency amplifier according to a third embodiment of the present invention;
FIG. 9 is a configuration diagram illustrating a connection form of the first to fourth inductive elements 31 to 34 in a polyphase filter 5;
FIG. 10 is an explanatory diagram illustrating parasitic capacitance 2-1a of a first transistor 2-1 to parasitic capacitance 2-4a of a fourth transistor 2-4;
FIG. 11 is a configuration diagram illustrating a high frequency amplifier according to a fourth embodiment of the present invention;
FIG. 12 is an explanatory diagram illustrating a parasitic capacitance 2-1a of a first transistor 2-1 to a parasitic capacitance 2-4a of a fourth transistor 2-4;
FIG. 13 is a configuration diagram illustrating a high frequency amplifier according to a fifth embodiment of the present invention;
FIG. 14 is a configuration diagram illustrating a high frequency amplifier according to a sixth embodiment of the present invention;
FIG. 15 is a configuration diagram illustrating a high frequency amplifier according to a seventh embodiment of the present invention;
FIG. 16A is an explanatory diagram illustrating an exemplary layout of inductive elements 61-1 to 61-4; and
FIG. 16B is an explanatory diagram illustrating an equivalent circuit of the inductive elements 61-1 to 61-4.

### DESCRIPTION OF EMBODIMENTS

Hereinafter, embodiments of the present invention will be described to explain the present invention in more detail with reference to the accompanying drawings.

### First Embodiment

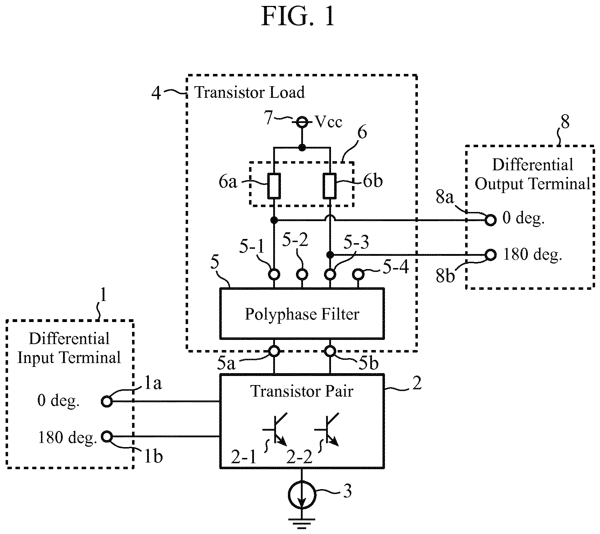

FIG. 1 is a configuration diagram illustrating a high frequency amplifier according to a first embodiment of the present invention.

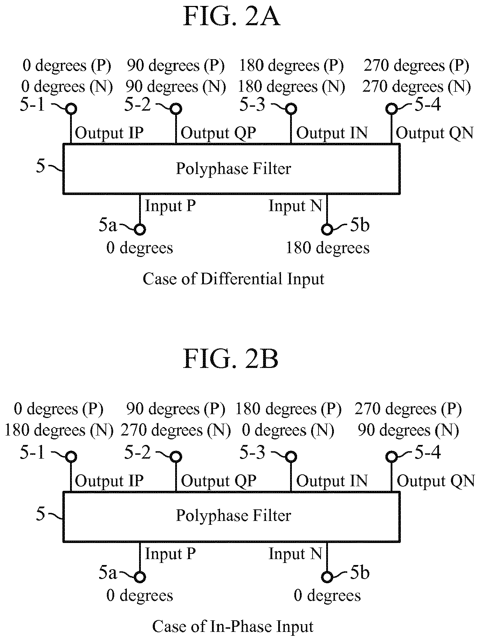

FIG. 2 is an explanatory diagram illustrating a phase of signals input/output by a polyphase filter 5 in the high frequency amplifier of FIG. 1.

FIG. 2A illustrates a phase at each terminal in the case where the signals input by the polyphase filter 5 are differential signals, and FIG. 2B illustrates a phase at each terminal in the case where the signals input by the polyphase filter 5 are in-phase signals.

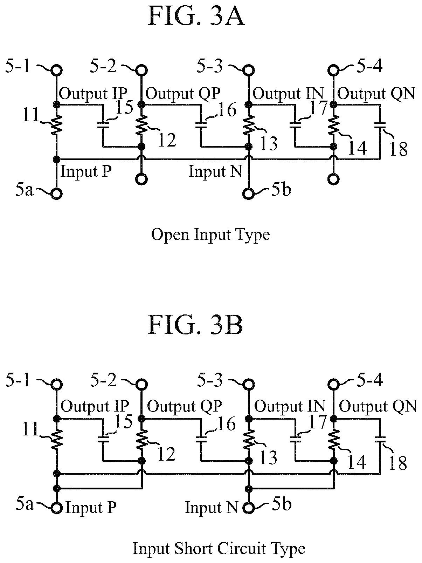

FIG. 3 is a configuration diagram illustrating an internal circuit of the polyphase filter 5 in the high frequency amplifier of FIG. 1.

FIG. 3A illustrates an internal circuit in the case where the polyphase filter 5 is an open input type, and FIG. 3B illustrates an internal circuit in the case where the polyphase filter 5 is an input short circuit type.

In FIGS. 1 to 3, a differential input terminal 1 includes a first signal input terminal 1a and a second signal input terminal 1b, which is a terminal for inputting differential signals including first and second signals.

The first signal input terminal 1a is a terminal for receiving the first signals.

The second signal input terminal 1b is a terminal for receiving the second signals.

A transistor pair 2 includes a first transistor 2-1 and a second transistor 2-2.

Each of the first transistor 2-1 and the second transistor 2-2 is implemented by, for example, a bipolar transistor, a metal-oxide semiconductor field-effect transistor (MOSFET), or the like.

In the first transistor 2-1, a base terminal that is a control terminal is connected to the first signal input terminal 1a, an emitter terminal is connected to a current source 3, and a collector terminal that is an output terminal is connected to a first input terminal 5a of the polyphase filter 5.

The first transistor 2-1 amplifies the first signals input from the first signal input terminal 1a, and outputs the amplified first signals to the first input terminal 5a of the polyphase filter 5.

In the second transistor 2-2, a base terminal that is a control terminal is connected to the second signal input terminal 1b, an emitter terminal is connected to the current source 3, and a collector terminal that is an output terminal is connected to a second input terminal 5b of the polyphase filter 5.

The second transistor 2-2 amplifies the second signals input from the second signal input terminal 1b, and outputs the amplified second signals to the second input terminal 5b of the polyphase filter 5.

One end of the current source 3 is connected to the emitter terminal of the first transistor 2-1 and the emitter terminal of the second transistor 2-2, and the other end is connected to the ground.

A transistor load 4 includes the polyphase filter 5, a load group 6, and a power supply 7.

The transistor load 4 is a load connected to each of the output terminal of the first transistor 2-1 and the output terminal of the second transistor 2-2.

In order to increase the gain of the high frequency amplifier including the transistor pair 2, it is necessary to increase the impedance of the transistor load 4.

The polyphase filter 5 includes the first input terminal 5a connected to the output terminal of the first transistor 2-1, and the second input terminal 5b connected to the output terminal of the second transistor 2-2.

In FIGS. 2 and 3, the first input terminal 5a is denoted by an input P, and the second input terminal 5b is denoted by an input N.

The polyphase filter 5 includes a first output terminal 5-1, a second output terminal 5-2, a third output terminal 5-3, and a fourth output terminal 5-4.

In FIGS. 2 and 3, the first output terminal 5-1 is denoted by an output IP, and the second output terminal 5-2 is denoted by an output QP. Further, the third output terminal 5-3 is denoted by an output IN, and the fourth output terminal 5-4 is denoted by an output QN.

When the first signals amplified by the first transistor 2-1 are input from the first input terminal 5a, the polyphase filter 5 generates first differential signals from the first signals, and outputs the first differential signals from the first output terminal 5-1 and the third output terminal 5-3.

Further, when the second signals amplified by the second transistor 2-2 are input from the second input terminal 5b, the polyphase filter 5 generates second differential signals from the second signals, and outputs the second differential signals from the first output terminal 5-1 and the third output terminal 5-3.

The load group 6 includes a load 6a and a load 6b.

Each of the load 6a and the load 6b is implemented by, for example, a resistor, an inductive element, or the like.

One end of the load 6a is connected to the first output terminal 5-1 of the polyphase filter 5, and the other end is connected to the power supply 7.

One end of the load 6b is connected to the third output terminal 5-3 of the polyphase filter 5, and the other end is connected to the power supply 7.

A differential output terminal 8 includes an amplifier output terminal 8a and an amplifier output terminal 8b.

The amplifier output terminal 8a is connected to the first output terminal 5-1 of the polyphase filter 5.

The amplifier output terminal 8b is connected to the third output terminal 5-3 of the polyphase filter 5.

Hereinafter, an internal circuit in the case where the polyphase filter 5 is an open input type will be described.

In FIG. 3A, one end of a resistor 11 is connected to the first input terminal 5a, and the other end is connected to the first output terminal 5-1.

One end of a resistor 12 is connected to the second output terminal 5-2.

One end of a resistor 13 is connected to the second input terminal 5b, and the other end is connected to the third output terminal 5-3.

One end of a resistor 14 is connected to the fourth output terminal 5-4.

One end of a capacitive element 15 is connected to the first output terminal 5-1, and the other end is connected to the other end of the resistor 12.

One end of a capacitive element 16 is connected to the second output terminal 5-2, and the other end is connected to the second input terminal 5b.

One end of a capacitive element 17 is connected to the third output terminal 5-3, and the other end is connected to the other end of the resistor 14.

One end of a capacitive element 18 is connected to the fourth output terminal 5-4, and the other end is connected to the first input terminal 5a.

In the case where the polyphase filter 5 is an input short circuit type, the other end of the resistor 12 and the other end of the capacitive element 15 are connected to the first input terminal 5a, as illustrated in FIG. 3B.

Further, the other end of the resistor 14 and the other end of the capacitive element 17 are connected to the second input terminal 5b.

Operation of the polyphase filter 5 in the case of the open input type and operation of the polyphase filter 5 in the case of the input short circuit type are similar.

Next, the operation will be described.

When the first signals are input from the first signal input terminal 1a, the first transistor 2-1 amplifies the first signals, and outputs the amplified first signals to the first input terminal 5a of the polyphase filter 5.

When the second signals are input from the second signal input terminal 1b, the second transistor 2-2 amplifies the second signals, and outputs the amplified second signals to the second input terminal 5b of the polyphase filter 5.

When the first signals amplified by the first transistor 2-1 are input from the first input terminal 5a, the polyphase filter 5 generates first differential signals from the first signals, and outputs the first differential signals from the first output terminal 5-1 and the third output terminal 5-3.

Further, when the second signals amplified by the second transistor 2-2 are input from the second input terminal 5b, the polyphase filter 5 generates second differential signals from the second signals, and outputs the second differential signals from the first output terminal 5-1 and the third output terminal 5-3.

FIG. 2A illustrates a case where the first signals having a phase of 0 degrees are input from the first signal input terminal 1a so that the first signals having the phase of 0 degrees are output from the first transistor 2-1, and the second signals having a phase of 180 degrees are input from the second signal input terminal 1b so that the second signals having the phase of 180 degrees are output from the second transistor 2-2.

In the example of FIG. 2A, the polyphase filter 5 generates, as first differential signals, differential signals including signals having a phase of 0 degrees and signals having a phase of 180 degrees, outputs the signals having the phase of 0 degrees from the first output terminal 5-1, and outputs the signals having the phase of 180 degrees from the third output terminal 5-3.

Further, the polyphase filter 5 generates, as second differential signals, differential signals including signals having a phase of 0 degrees and signals having a phase of 180 degrees, outputs the signals having the phase of 0 degrees from the first output terminal 5-1, and outputs the signals having the phase of 180 degrees from the third output terminal 5-3.

Accordingly, at the first output terminal 5-1 of the polyphase filter 5, the signals having the phase of 0 degrees included in the first differential signals and the signals having the phase of 0 degrees included in the second differential signals are subject to in-phase synthesis, thereby amplifying the signals having the phase of 0 degrees.

Further, at the third output terminal 5-3 of the polyphase filter 5, the signals having the phase of 180 degrees included in the first differential signals and the signals having the phase of 180 degrees included in the second differential signals are subject to in-phase synthesis, thereby amplifying the signals having the phase of 180 degrees.

When the signals having the phase of 0 degrees are output from the first output terminal 5-1 of the polyphase filter 5, signals having a phase of 0 degrees are output from the amplifier output terminal 8a.

Further, when the signals having the phase of 180 degrees are output from the third output terminal 5-3 of the polyphase filter 5, signals having a phase of 180 degrees are output from the amplifier output terminal 8b.

Note that, at the time of generating the first and second differential signals, the polyphase filter 5 generates third differential signals having a phase shifted by 90 degrees from that of the first differential signals, and outputs the third differential signals from the second output terminal 5-2 and the fourth output terminal 5-4. That is, the polyphase filter 5 generates, as the third differential signals, differential signals including signals having a phase of 90 degrees and signals having a phase of 270 degrees, outputs the signals having the phase of 90 degrees from the second output terminal 5-2, and outputs the signals having the phase of 270 degrees from the fourth output terminal 5-4.

Further, the polyphase filter 5 generates fourth differential signals having a phase shifted by 90 degrees from that of the second differential signals, and outputs the fourth differential signals from the second output terminal 5-2 and the fourth output terminal 5-4. That is, the polyphase filter 5 generates, as the fourth differential signals, differential signals including signals having a phase of 90 degrees and signals having a phase of 270 degrees, outputs the signals having the phase of 90 degrees from the second output terminal 5-2, and outputs the signals having the phase of 270 degrees from the fourth output terminal 5-4.

However, since each of the second output terminal 5-2 and the fourth output terminal 5-4 of the polyphase filter 5 is open, the signals having the phase of 90 degrees are not output from the output terminal 5-2 to the differential output terminal 8. In addition, the signals having the phase of 270 degrees are not output from the output terminal 5-4 to the differential output terminal 8.

When the first transistor 2-1 amplifies the first signals and the second transistor 2-2 amplifies the second signals, in-phase signals having a phase of 0 degrees may be input to the differential input terminal 1.

In the case where the in-phase signals having the phase of 0 degrees are input to the differential input terminal 1, the in-phase signals are amplified by each of the first transistor 2-1 and the second transistor 2-2. Thereafter, as illustrated in FIG. 2B, the signals having the phase of 0 degrees are input from each of the first input terminal 5a and the second input terminal 5b of the polyphase filter 5.

In this case, the polyphase filter 5 generates differential signals including signals having a phase of 0 degrees and signals having a phase of 180 degrees from the signals having the phase of 0 degrees input from the first input terminal 5a, outputs the signals having the phase of 0 degrees from the first output terminal 5-1, and outputs the signals having the phase of 180 degrees from the third output terminal 5-3.

Further, the polyphase filter 5 generates differential signals including signals having a phase of 180 degrees and signals having a phase of 0 degrees from the signals having the phase of 0 degrees input from the second input terminal 5b, outputs the signals having the phase of 180 degrees from the first output terminal 5-1, and outputs the signals having the phase of 0 degrees from the third output terminal 5-3.

Further, the polyphase filter 5 generates differential signals including signals having a phase of 90 degrees and signals having a phase of 270 degrees from the signals having the phase of 0 degrees input from the first input terminal 5a, outputs the signals having the phase of 90 degrees from the second output terminal 5-2, and outputs the signals having the phase of 270 degrees from the fourth output terminal 5-4.

Further, the polyphase filter 5 generates differential signals including signals having a phase of 270 degrees and signals having a phase of 90 degrees from the signals having the phase of 0 degrees input from the second input terminal 5b, outputs the signals having the phase of 270 degrees from the second output terminal 5-2, and outputs the signals having the phase of 90 degrees from the fourth output terminal 5-4.

As a result, at the first output terminal 5-1 of the polyphase filter 5, the signals having the phase of 0 degrees, which are generated from the signals having the phase of 0 degrees input from the first input terminal 5a, and the signals having the phase of 180 degrees, which are generated from the signals having the phase of 0 degrees input from the second input terminal 5b, cancel each other out.

Further, at the third output terminal 5-3 of the polyphase filter 5, the signals having the phase of 180 degrees, which are generated from the signals having the phase of 0 degrees input from the first input terminal 5a, and the signals having the phase of 0 degrees, which are generated from the signals having the phase of 0 degrees input from the second input terminal 5b, cancel each other out.

At the second output terminal 5-2 of the polyphase filter 5, the signals having the phase of 90 degrees, which are generated from the signals having the phase of 0 degrees input from the first input terminal 5a, and the signals having the phase of 270 degrees, which are generated from the signals having the phase of 0 degrees input from the second input terminal 5b, cancel each other out.

Furthermore, at the second output terminal 5-4 of the polyphase filter 5, the signals having the phase of 270 degrees, which are generated from the signals having the phase of 0 degrees input from the first input terminal 5a, and the signals having the phase of 90 degrees, which are generated from the signals having the phase of 0 degrees input from the second input terminal 5b, cancel each other out.

Therefore, the output of the in-phase signals from the polyphase filter 5 is suppressed.

As apparent from the above, according to the first embodiment, there is provided the polyphase filter 5 that generates the first differential signals from the first signals amplified by the first transistor 2-1, outputs the first differential signals from the first output terminal 5-1 and the third output terminal 5-3, generates the second differential signals from the second signals amplified by the second transistor 2-2, and outputs the second differential signals from the first output terminal 5-1 and the third output terminal 5-3, whereby the output of the in-phase signals can be suppressed.

In the first embodiment, an exemplary case where the load group 6 includes the load 6a and the load 6b, and the differential output terminal 8 includes the amplifier output terminal 8a and the amplifier output terminal 8b is described.

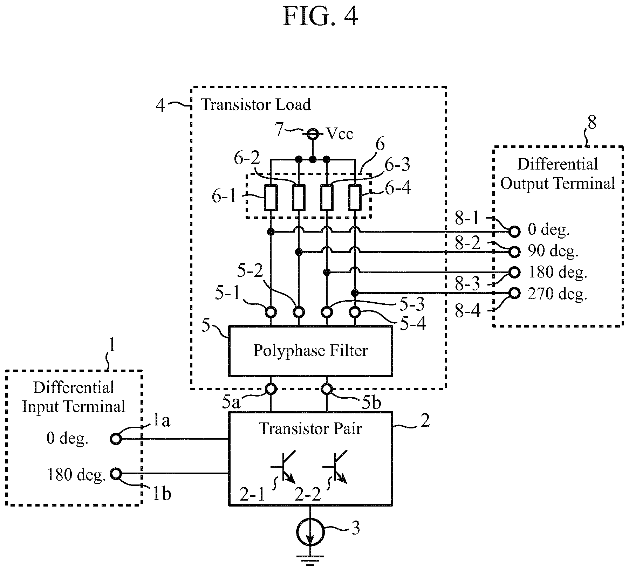

However, this is merely an example, and for example, the load group 6 may include loads 6-1 to 6-4, and the differential output terminal 8 may include amplifier output terminals 8-1 to 8-4, as illustrated in FIG. 4.

FIG. 4 is a configuration diagram illustrating another high frequency amplifier according to the first embodiment of the present invention.

In FIG. 4, each of the loads 6-1 to 6-4 is implemented by, for example, a resistor, an inductive element, or the like.

One end of the load 6-1 is connected to the first output terminal 5-1 of the polyphase filter 5, and the other end is connected to the power supply 7.

One end of the load 6-2 is connected to the second output terminal 5-2 of the polyphase filter 5, and the other end is connected to the power supply 7.

One end of the load 6-3 is connected to the third output terminal 5-3 of the polyphase filter 5, and the other end is connected to the power supply 7.

One end of the load 6-4 is connected to the fourth output terminal 5-4 of the polyphase filter 5, and the other end is connected to the power supply 7.

The amplifier output terminal 8-1 is connected to the first output terminal 5-1 of the polyphase filter 5.

The amplifier output terminal 8-2 is connected to the second output terminal 5-2 of the polyphase filter 5.

The amplifier output terminal 8-3 is connected to the third output terminal 5-3 of the polyphase filter 5.

The amplifier output terminal 8-4 is connected to the fourth output terminal 5-4 of the polyphase filter 5.

In the case of the high frequency amplifier illustrated in FIG. 4 as well, in a similar manner to the case of the high frequency amplifier illustrated in FIG. 1, the signals having the phase of 0 degrees are output from the first output terminal 5-1 of the polyphase filter 5, and the signals having the phase of 0 degrees are output from the amplifier output terminal 8-1.

Further, the signals having the phase of 180 degrees are output from the third output terminal 5-3 of the polyphase filter 5, and the signals having the phase of 180 degrees are output from the amplifier output terminal 8-3.

At the second output terminal 5-2 of the polyphase filter 5, the signals having the phase of 90 degrees included in the first differential signals and the signals having the phase of 90 degrees included in the second differential signals are subject to in-phase synthesis, thereby amplifying the signals having the phase of 90 degrees.

Further, at the fourth output terminal 5-4 of the polyphase filter 5, the signals having the phase of 270 degrees included in the first differential signals and the signals having the phase of 270 degrees included in the second differential signals are subject to in-phase synthesis, thereby amplifying the signals having the phase of 270 degrees.

As a result, the signals having the phase of 90 degrees are output from the second output terminal 5-2 of the polyphase filter 5, and the signals having the phase of 90 degrees are output from the amplifier output terminal 8-2.

Further, the signals having the phase of 270 degrees are output from the fourth output terminal 5-4 of the polyphase filter 5, and the signals having the phase of 270 degrees are output from the amplifier output terminal 8-4.

In the first embodiment, an exemplary case where the load group 6 includes the load 6a and the load 6b is described.

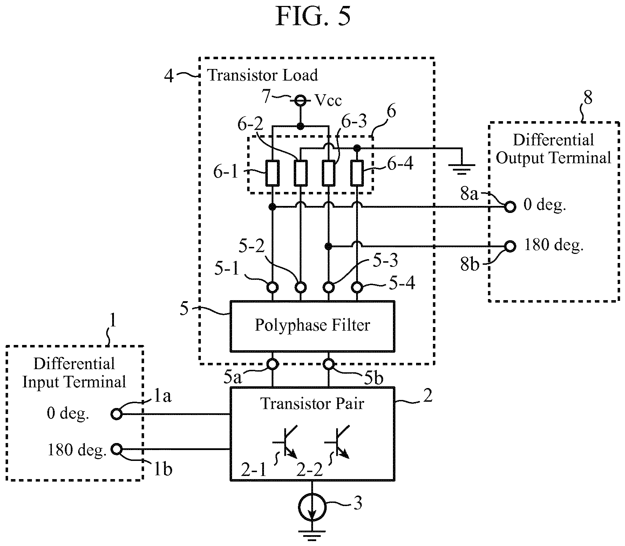

However, this is merely an example, and for example, the load group 6 may include the loads 6-1 to 6-4, as illustrated in FIG. 5.

FIG. 5 is a configuration diagram illustrating still another high frequency amplifier according to the first embodiment of the present invention.

In the example of FIG. 5, in order to maintain the symmetry of the circuit, the loads 6-1 to 6-4 are connected to the first to fourth output terminals 5-1 to 5-4 of the polyphase filter 5, respectively.

Note that the other end of the load 6-2 and the other end of the load 6-4, which are not connected to the amplifier output terminal, are connected to the ground.

### Second Embodiment

In the first embodiment, an exemplary case where the polyphase filter 5 includes the capacitive elements 15 to 18 has been described.

In a second embodiment, an exemplary case where a polyphase filter 5 includes a first to fourth inductive elements 25 to 28 will be described.

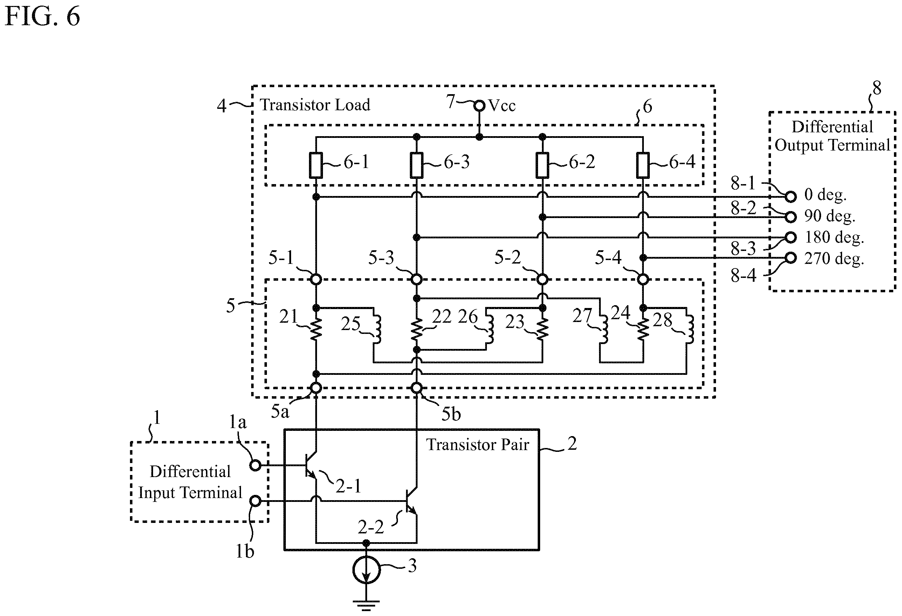

FIG. 6 is a configuration diagram illustrating a high frequency amplifier according to the second embodiment of the present invention.

In FIG. 6, the reference signs same as those in FIGS. 1 and 4 indicate the same or corresponding parts, and thus descriptions thereof will be omitted.

The polyphase filter 5 includes a first resistor 21, a second resistor 22, a third resistor 23, a fourth resistor 24, a first inductive element 25, a second inductive element 26, a third inductive element 27, and a fourth inductive element 28.

The polyphase filter 5 is configured in such a manner that the first resistor 21, the first inductive element 25, the third resistor 23, the second inductive element 26, the second resistor 22, the third inductive element 27, the fourth resistor 24, and the fourth inductive element 28 are annularly connected in that order.

Specifically, they are connected as follows.

One end of the first resistor 21 is connected to a first input terminal 5a, and the other end is connected to a first output terminal 5-1.

One end of the second resistor 22 is connected to a second input terminal 5b, and the other end is connected to a third output terminal 5-3.

One end of the third resistor 23 is connected to the other end of the first inductive element 25, and the other end is connected to a second output terminal 5-2.

One end of the fourth resistor 24 is connected to the other end of the third inductive element 27, and the other end is connected to a fourth output terminal 5-4.

One end of the first inductive element 25 is connected to the first output terminal 5-1, and the other end is connected to one end of the third resistor 23.

One end of the second inductive element 26 is connected to the second input terminal 5b, and the other end is connected to the second output terminal 5-2.

One end of the third inductive element 27 is connected to the third output terminal 5-3, and the other end is connected to one end of the fourth resistor 24.

One end of the fourth inductive element 28 is connected to the first input terminal 5a, and the other end is connected to the fourth output terminal 5-4.

Next, the operation will be described.

When the first signals are input from the first signal input terminal 1a, the first transistor 2-1 amplifies the first signals, and outputs the amplified first signals to the first input terminal 5a of the polyphase filter 5.

When the second signals are input from the second signal input terminal 1b, the second transistor 2-2 amplifies the second signals, and outputs the amplified second signals to the second input terminal 5b of the polyphase filter 5.

When the first signals amplified by the first transistor 2-1 are input from the first input terminal 5a, the polyphase filter 5 generates first differential signals from the first signals, and outputs the first differential signals from the first output terminal 5-1 and the third output terminal 5-3.

Further, when the second signals amplified by the second transistor 2-2 are input from the second input terminal 5b, the polyphase filter 5 generates second differential signals from the second signals, and outputs the second differential signals from the first output terminal 5-1 and the third output terminal 5-3.

In the second embodiment, the polyphase filter 5 includes, instead of the capacitive elements 15 to 18, the first to fourth inductive elements 25 to 28. In a similar manner to the first embodiment, in the case where a phase of the first signals input from the first input terminal 5a is 0 degrees and a phase of the second signals input from the second input terminal 5b is 180 degrees, the polyphase filter 5 outputs signals similar to those in the first embodiment.

That is, signals having a phase of 0 degrees are output from the first output terminal 5-1 of the polyphase filter 5, and signals having a phase of 90 degrees are output from the second output terminal 5-2 of the polyphase filter 5.

Further, signals having a phase of 180 degrees are output from the third output terminal 5-3 of the polyphase filter 5, and signals having a phase of 270 degrees are output from the fourth output terminal 5-4 of the polyphase filter 5.

Note that output of in-phase signals from the polyphase filter 5 can be suppressed on the basis of a principle similar to that in the first embodiment.

When the high frequency amplifier of FIG. 6 is amplifying the differential signals input from a differential input terminal 1, the output terminal of the first transistor 2-1, the output terminal of the second transistor 2-2, and loads 6-1 to 6-4 are galvanically short-circuited via the first to fourth inductive elements 25 to 28 in the polyphase filter 5.

Accordingly, while a direct voltage is applied to the loads 6-1 to 6-4, the first transistor 2-1, the second transistor 2-2, and a current source 3, a direct voltage is not applied to the polyphase filter 5, whereby no voltage drop occurs in the polyphase filter 5.

As a result, the voltage between the emitter and the collector of the first transistor 2-1 and the voltage between the emitter and the collector of the second transistor 2-2 can be maintained higher than those in the first embodiment, whereby the gain of the high frequency amplifier can be increased.

As apparent from the above, while the polyphase filter 5 includes the first to fourth inductive elements 25 to 28 instead of the capacitive elements 15 to 18 in the second embodiment, output of in-phase signals can be suppressed in a similar manner to the first embodiment.

In addition, since the polyphase filter 5 includes the first to fourth inductive elements 25 to 28, the gain of the high frequency amplifier can be made higher than that in the first embodiment.

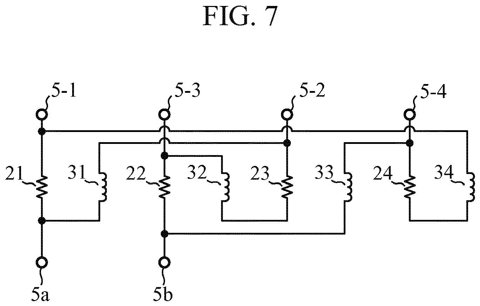

Although an exemplary case where the polyphase filter 5 includes the first to fourth inductive elements 25 to 28 is described in the second embodiment, the connection form of the first to fourth inductive elements 25 to 28 is not limited to the example illustrated in FIG. 6, and may be, for example, a connection form as illustrated in FIG. 7.

FIG. 7 is a configuration diagram illustrating a connection form of first to fourth inductive elements 31 to 34 in the polyphase filter 5.

The polyphase filter 5 illustrated in FIG. 7 includes the first resistor 21, the second resistor 22, the third resistor 23, the fourth resistor 24, a first inductive element 31, a second inductive element 32, a third inductive element 33, and a fourth inductive element 34.

The polyphase filter 5 is configured in such a manner that the first resistor 21, the first inductive element 31, the third resistor 23, the second inductive element 32, the second resistor 22, the third inductive element 33, the fourth resistor 24, and the fourth inductive element 34 are annularly connected in that order.

Specifically, they are connected as follows.

One end of the first inductive element 31 is connected to the first input terminal 5a, and the other end is connected to the second output terminal 5-2.

One end of the second inductive element 32 is connected to the third output terminal 5-3, and the other end is connected to one end of the third resistor 23.

One end of the third inductive element 33 is connected to the second input terminal 5b, and the other end is connected to the fourth output terminal 5-4.

One end of the fourth inductive element 34 is connected to the first output terminal 5-1, and the other end is connected to one end of the fourth resistor 24.

Even when the connection form of the first to fourth inductive elements 31 to 34 in the polyphase filter 5 is the connection form illustrated in FIG. 7, the polyphase filter 5 that acts in a similar manner to the connection form illustrated in FIG. 6 can be obtained.

### Third Embodiment

In a third embodiment, an exemplary case where a transistor pair 2 includes, in addition to a first transistor 2-1 and a second transistor 2-2, a third transistor 2-3 and a fourth transistor 2-4 will be described.

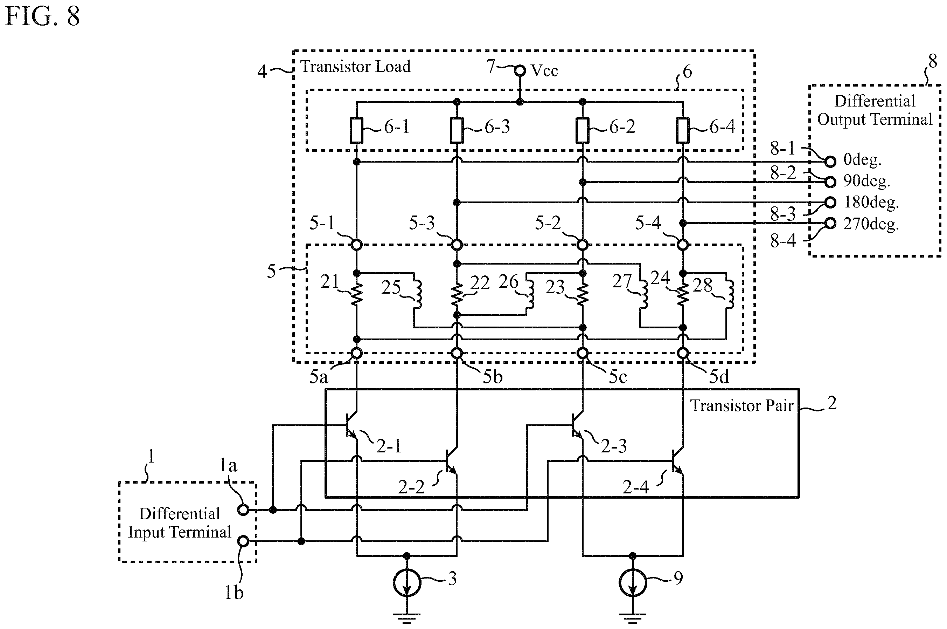

FIG. 8 is a configuration diagram illustrating a high frequency amplifier according to the third embodiment of the present invention.

In FIG. 8, the reference signs same as those in FIGS. 1 and 6 indicate the same or corresponding parts, and thus descriptions thereof will be omitted.

Each of the third transistor 2-3 and the fourth transistor 2-4 is implemented by, for example, a bipolar transistor, a MOSFET, or the like.

In the third transistor 2-3, a base terminal that is a control terminal is connected to a first signal input terminal 1a, an emitter terminal is connected to a current source 9, and a collector terminal that is an output terminal is connected to a third input terminal 5c of a polyphase filter 5.

The third transistor 2-3 amplifies first signals input from the first signal input terminal 1a, and outputs the amplified first signals to the third input terminal 5c of the polyphase filter 5.

In the fourth transistor 2-4, a base terminal that is a control terminal is connected to a second signal input terminal 1b, an emitter terminal is connected to the current source 9, and a collector terminal that is an output terminal is connected to a fourth input terminal 5d of the polyphase filter 5.

The fourth transistor 2-4 amplifies second signals input from the second signal input terminal 1b, and outputs the amplified second signals to the fourth input terminal 5d of the polyphase filter 5.

The polyphase filter 5 includes, in a similar manner to the first embodiment, a first input terminal 5a connected to the output terminal of the first transistor 2-1, and a second input terminal 5b connected to the output terminal of the second transistor 2-2.

In addition, the polyphase filter 5 includes a third input terminal 5c connected to the output terminal of the third transistor 2-3, and a fourth input terminal 5d connected to the output terminal of the fourth transistor 2-4.

The third input terminal 5c is connected to one end of a third resistor 23, and the other end of a first inductive element 25.

The fourth input terminal 5d is connected to one end of a fourth resistor 24, and the other end of a third inductive element 27.

One end of the current source 9 is connected to the emitter terminal of the third transistor 2-3 and the emitter terminal of the fourth transistor 2-4, and the other end is connected to the ground.

Next, the operation will be described.

When the first signals are input from the first signal input terminal 1a, the first transistor 2-1 amplifies the first signals, and outputs the amplified first signals to the first input terminal 5a of the polyphase filter 5.

When the second signals are input from the second signal input terminal 1b, the second transistor 2-2 amplifies the second signals, and outputs the amplified second signals to the second input terminal 5b of the polyphase filter 5.

When the first signals are input from the first signal input terminal 1a, the third transistor 2-3 amplifies the first signals, and outputs the amplified first signals to the third input terminal 5c of the polyphase filter 5.

When the second signals are input from the second signal input terminal 1b, the fourth transistor 2-4 amplifies the second signals, and outputs the amplified second signals to the fourth input terminal 5d of the polyphase filter 5.

When the first signals amplified by the first transistor 2-1 are input from the first input terminal 5a and the first signals amplified by the third transistor 2-3 are input from the third input terminal 5c, the polyphase filter 5 generates first differential signals from both of the input first signals, and outputs the first differential signals from a first output terminal 5-1 and a third output terminal 5-3.

Further, when the second signals amplified by the second transistor 2-2 are input from the second input terminal 5b and the second signals amplified by the fourth transistor 2-4 are input from the fourth input terminal 5d, the polyphase filter 5 generates second differential signals from both of the input second signals, and outputs the second differential signals from the first output terminal 5-1 and the third output terminal 5-3.

In the third embodiment, in the case where a phase of the first signals input from each of the first input terminal 5a and the third input terminal 5c is 0 degrees and a phase of the second signals input from each of the second input terminal 5b and the fourth input terminal 5d is 180 degrees, the polyphase filter 5 outputs signals similar to those in the first embodiment.

That is, signals having a phase of 0 degrees are output from the first output terminal 5-1 of the polyphase filter 5, and signals having a phase of 90 degrees are output from the second output terminal 5-2 of the polyphase filter 5.

Further, signals having a phase of 180 degrees are output from the third output terminal 5-3 of the polyphase filter 5, and signals having a phase of 270 degrees are output from the fourth output terminal 5-4 of the polyphase filter 5.

However, in the third embodiment, the transistor pair 2 includes the third transistor 2-3 and the fourth transistor 2-4 in addition to the first transistor 2-1 and the second transistor 2-2, thereby enhancing the symmetry of the circuit.

Accordingly, the phase accuracy of the signals output from the first to fourth output terminals 5-1 to 5-4 of the polyphase filter 5 is higher than that of the first embodiment.

That is, compared to the first embodiment, the signals output from the first output terminal 5-1 of the polyphase filter 5 are closer to 0 degrees, and the signals output from the third output terminal 5-3 of the polyphase filter 5 are closer to 180 degrees.

Further, compared to the first embodiment, the signals output from the second output terminal 5-2 of the polyphase filter 5 are closer to 90 degrees, and the signals output from the fourth output terminal 5-4 of the polyphase filter 5 are closer to 270 degrees.

Note that output of in-phase signals from the polyphase filter 5 can be suppressed on the basis of a principle similar to that in the first embodiment.

When the high frequency amplifier of FIG. 8 is amplifying the differential signals input from a differential input terminal 1, the output terminals of the first to fourth transistors 2-1 to 2-4 and loads 6-1 to 6-4 are galvanically short-circuited via first to fourth inductive elements 25 to 28 in the polyphase filter 5.

Accordingly, while a direct voltage is applied to the loads 6-1 to 6-4, the first transistor 2-1, the second transistor 2-2, the third transistor 2-3, the fourth transistor 2-4, and the current sources 3 and 9, a direct voltage is not applied to the polyphase filter 5, whereby no voltage drop occurs in the polyphase filter 5.

As a result, the voltage between the emitter and the collector of the first to fourth transistors 2-1 to 2-4 can be maintained higher than that in the first embodiment, whereby the gain of the high frequency amplifier can be increased.

As apparent from the above, according to the third embodiment, the transistor pair 2 includes the third transistor 2-3 and the fourth transistor 2-4 in addition to the first transistor 2-1 and the second transistor 2-2, whereby the effects similar to those in the first embodiment can be obtained, and the symmetry of the circuit is enhanced so that the phase accuracy of the signals output from the first to fourth output terminals 5-1 to 5-4 of the polyphase filter 5 can be enhanced.

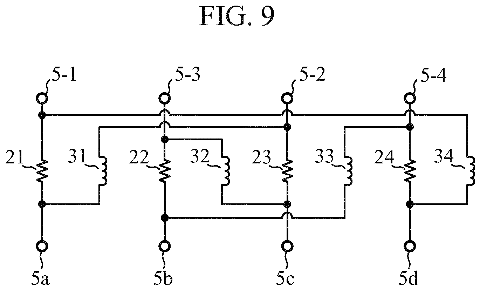

Although an exemplary case where the polyphase filter 5 includes the first to fourth inductive elements 25 to 28 is described in the third embodiment, the connection form of the first to fourth inductive elements 25 to 28 is not limited to the example illustrated in FIG. 8, and may be, for example, a connection form as illustrated in FIG. 9.

FIG. 9 is a configuration diagram illustrating a connection form of first to fourth inductive elements 31 to 34 in the polyphase filter 5.

Although an exemplary case where the polyphase filter 5 includes the first to fourth inductive elements 25 to 28 is described in the third embodiment, the first inductive element 25 may have inductive reactance that cancels out parasitic capacitance 2-3a of the third transistor 2-3, and the second inductive element 26 may have inductive reactance that cancels out parasitic capacitance 2-2a of the second transistor 2-2.

Further, the third inductive element 27 may have inductive reactance that cancels out parasitic capacitance 2-4a of the fourth transistor 2-4, and the fourth inductive element 28 may have inductive reactance that cancels out parasitic capacitance 2-1a of the first transistor 2-1.

Accordingly, it is possible to cancel out the parasitic capacitance 2-1a to 2-4a, which adversely affects the amplification operation, when the high frequency amplifier amplifies high frequency signals.

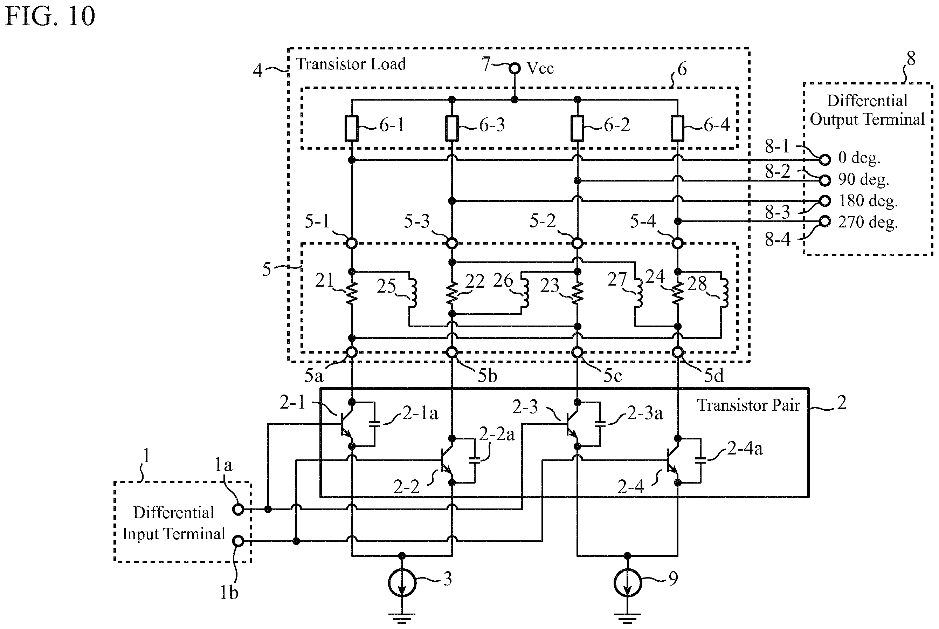

FIG. 10 is an explanatory diagram illustrating the parasitic capacitance 2-1a of the first transistor 2-1 to the parasitic capacitance 2-4a of the fourth transistor 2-4.

### Fourth Embodiment

In a fourth embodiment, an exemplary case where a first series circuit 41 is connected to a base terminal that is a control terminal of a third transistor 2-3 included in a transistor pair 2, and a second series circuit 44 is connected to a base terminal that is a control terminal of a fourth transistor 2-4 will be described.

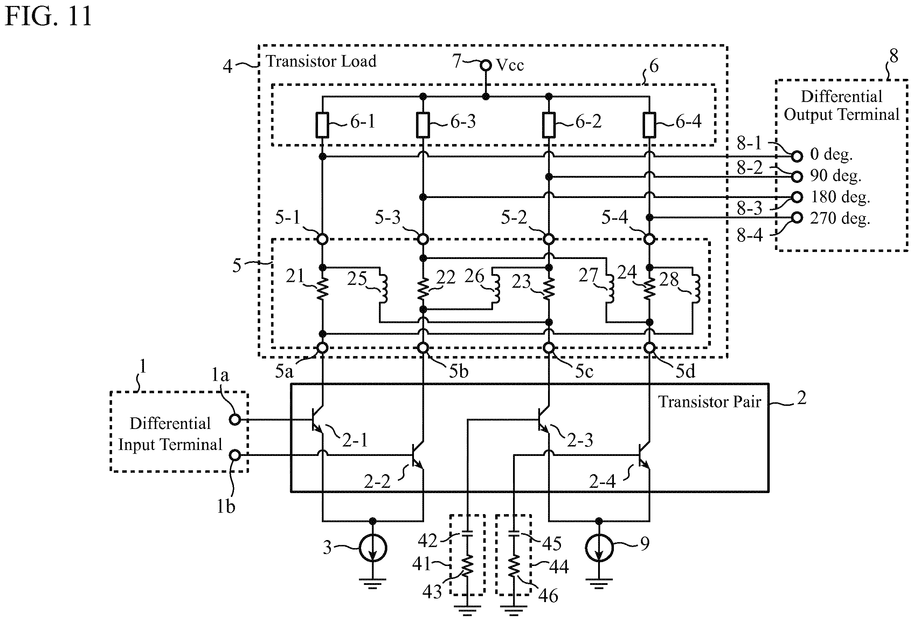

FIG. 11 is a configuration diagram illustrating a high frequency amplifier according to the fourth embodiment of the present invention.

In FIG. 11, the reference signs same as those in FIGS. 1 and 8 indicate the same or corresponding parts, and thus descriptions thereof will be omitted.

The first series circuit 41 is a circuit in which a capacitive element 42 and a resistor 43 are connected in series, and one end thereof is connected to the base terminal of the third transistor 2-3, and the other end is connected to the ground.

The second series circuit 44 is a circuit in which a capacitive element 45 and a resistor 46 are connected in series, and one end thereof is connected to the base terminal of the fourth transistor 2-4, and the other end is connected to the ground.

Next, the operation will be described.

Unlike the third embodiment, in the fourth embodiment, the base terminal of the third transistor 2-3 is input-terminated by the first series circuit 41, and the base terminal of the fourth transistor 2-4 is input-terminated by the second series circuit 44.

Accordingly, while the third transistor 2-3 does not amplify first signals and the fourth transistor 2-4 does not amplify second signals, input impedance at a third input terminal 5c of a polyphase filter 5 is matched with input impedance at a first input terminal 5a. Further, input impedance at a fourth input terminal 5d of the polyphase filter 5 is matched with input impedance at a second input terminal 5b.

This enhances the symmetry of the circuit compared to, for example, the high frequency amplifier of FIG. 6.

The operation of the polyphase filter 5 according to the fourth embodiment is similar to, for example, the operation of the polyphase filter 5 illustrated in FIG. 6.

Although an exemplary case where first to fourth inductive elements 25 to 28 in the polyphase filter 5 are connected as illustrated in FIG. 11 is described in the fourth embodiment, for example, the first to fourth inductive elements 25 to 28 in the polyphase filter 5 may be connected like the first to fourth inductive elements 31 to 32 illustrated in FIG. 9.

Although an exemplary case where the polyphase filter 5 includes the first to fourth inductive elements 25 to 28 is described in the fourth embodiment, the first inductive element 25 may have inductive reactance that cancels out parasitic capacitance 2-3a of the third transistor 2-3, and the second inductive element 26 may have inductive reactance that cancels out parasitic capacitance 2-2a of the second transistor 2-2.

Further, the third inductive element 27 may have inductive reactance that cancels out parasitic capacitance 2-4a of the fourth transistor 2-4, and the fourth inductive element 28 may have inductive reactance that cancels out parasitic capacitance 2-1a of the first transistor 2-1.

Accordingly, it is possible to cancel out the parasitic capacitance 2-1a to 2-4a, which adversely affects the amplification operation, when the high frequency amplifier amplifies high frequency signals.

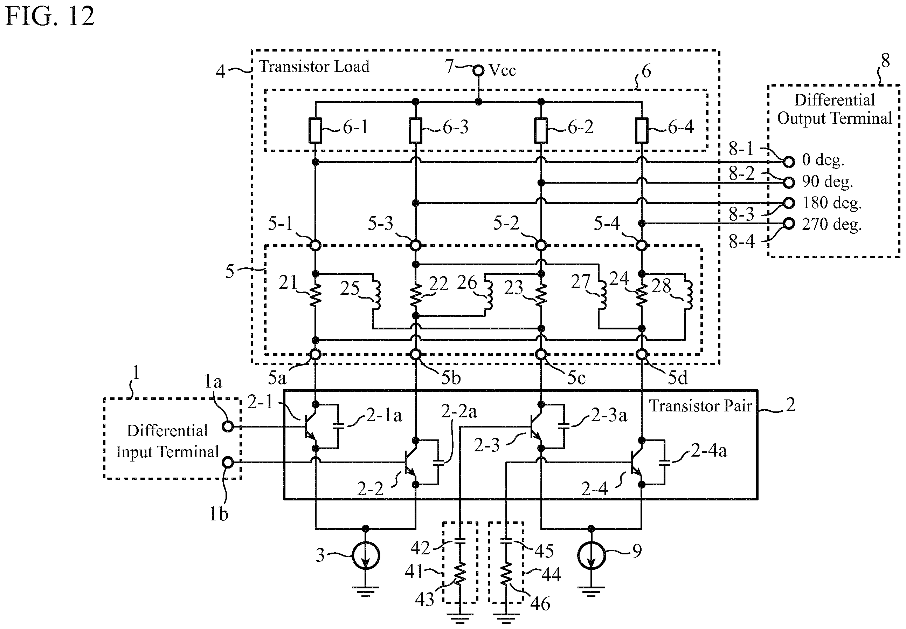

FIG. 12 is an explanatory diagram illustrating the parasitic capacitance 2-1a of the first transistor 2-1 to the parasitic capacitance 2-4a of the fourth transistor 2-4.

### Fifth Embodiment

In a fifth embodiment, an exemplary case where each of matching circuits for matching impedance is connected between first to fourth transistors 2-1 to 2-4 and a polyphase filter 5 will be described.

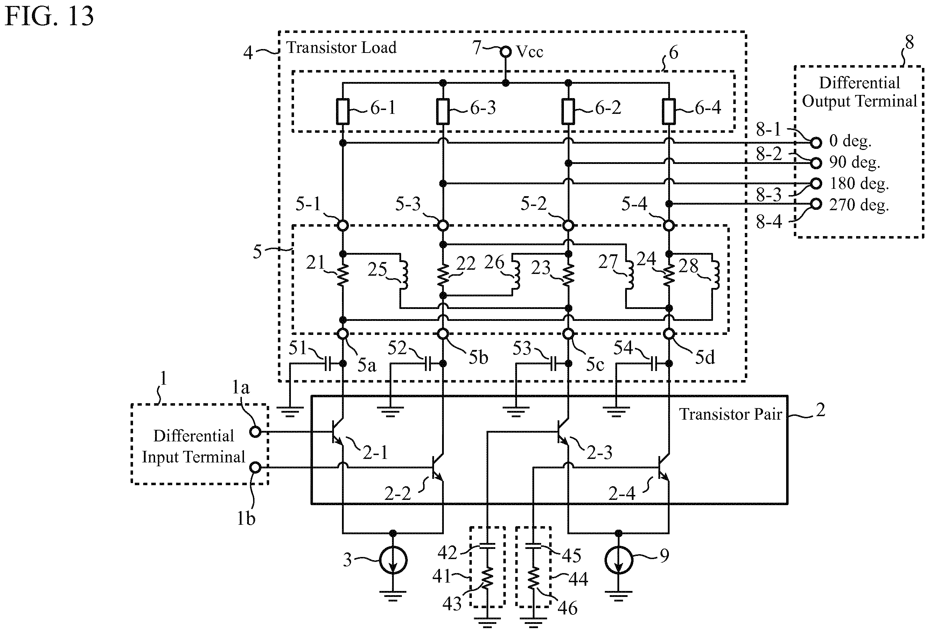

FIG. 13 is a configuration diagram illustrating a high frequency amplifier according to the fifth embodiment of the present invention.

In FIG. 13, the reference signs same as those in FIGS. 1 and 11 indicate the same or corresponding parts, and thus descriptions thereof will be omitted.

A capacitive element 51 has one end connected between a first input terminal 5a of the polyphase filter 5 and the ground, which is a first matching circuit for matching impedance between the first input terminal 5a of the polyphase filter 5 and the output terminal of the first transistor 2-1.

A capacitive element 52 has one end connected between a second input terminal 5b of the polyphase filter 5 and the ground, which is a second matching circuit for matching impedance between the second input terminal 5b of the polyphase filter 5 and the output terminal of the second transistor 2-2.

A capacitive element 53 has one end connected between a third input terminal 5c of the polyphase filter 5 and the ground, which is a third matching circuit for matching impedance between the third input terminal 5c of the polyphase filter 5 and the output terminal of the third transistor 2-3.

A capacitive element 54 has one end connected between a fourth input terminal 5d of the polyphase filter 5 and the ground, which is a fourth matching circuit for matching impedance between the fourth input terminal 5d of the polyphase filter 5 and the output terminal of the fourth transistor 2-4.

In the fifth embodiment, the high frequency amplifier includes the capacitive elements 51 to 54 that are the first to fourth matching circuits, thereby matching the impedance between the first to fourth transistors 2-1 to 2-4 and the polyphase filter 5.

Accordingly, the first signals output from the output terminal of the first transistor 2-1 are hardly reflected at the first input terminal 5a of the polyphase filter 5.

In addition, the second signals output from the output terminal of the second transistor 2-2 are hardly reflected at the second input terminal 5b of the polyphase filter 5.

Accordingly, the loss of the first signals and the second signals can be reduced, whereby the gain of the high frequency amplifier can be made higher than the first embodiment.

Although an exemplary case where first to fourth inductive elements 25 to 28 in the polyphase filter 5 are connected as illustrated in FIG. 13 is described in the fifth embodiment, for example, the first to fourth inductive elements 25 to 28 in the polyphase filter 5 may be connected like the first to fourth inductive elements 31 to 32 illustrated in FIG. 9.

### Sixth Embodiment

In the first embodiment described above, an exemplary case where the load group 6 includes the loads 6-1 to 6-4 is described.

In a sixth embodiment, an exemplary case where a plurality of loads included in a load group 6 is inductive elements 6-5 to 6-8 will be described.

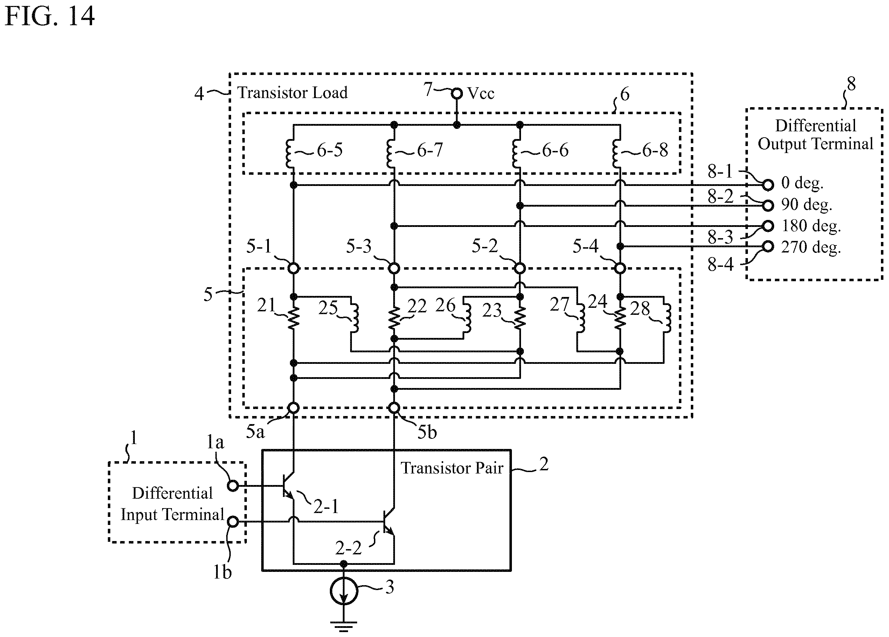

FIG. 14 is a configuration diagram illustrating a high frequency amplifier according to the sixth embodiment of the present invention.

In FIG. 14, the reference signs same as those in FIGS. 1 and 6 indicate the same or corresponding parts, and thus descriptions thereof will be omitted.

The load group 6 includes the inductive elements 6-5 to 6-8.

One end of the inductive element 6-5 is connected to a first output terminal 5-1 of the polyphase filter 5, and the other end is connected to a power supply 7.

One end of the inductive element 6-6 is connected to a second output terminal 5-2 of the polyphase filter 5, and the other end is connected to the power supply 7.

One end of the inductive element 6-7 is connected to a third output terminal 5-3 of the polyphase filter 5, and the other end is connected to the power supply 7.

One end of the inductive element 6-8 is connected to a fourth output terminal 5-4 of the polyphase filter 5, and the other end is connected to the power supply 7.

When the high frequency amplifier of FIG. 14 is amplifying differential signals input from a differential input terminal 1, the output terminal of a first transistor 2-1, the output terminal of a second transistor 2-2, and the inductive elements 6-5 to 6-8 are galvanically short-circuited via first to fourth inductive elements 25 to 28 in the polyphase filter 5.

Note that the plurality of loads included in the load group 6 is the inductive elements 6-5 to 6-8.

Accordingly, while a direct voltage is applied to the first transistor 2-1, the second transistor 2-2, and a current source 3, a direct voltage is not applied to the polyphase filter 5 and the load group 6, whereby no voltage drop occurs in the polyphase filter 5 and the load group 6.

As a result, the voltage between the emitter and the collector of the first and second transistors 2-1 and 2-2 can be maintained higher than that in the first embodiment, whereby the gain of the high frequency amplifier can be increased.

Although an exemplary case where the first to fourth inductive elements 25 to 28 in the polyphase filter 5 are connected as illustrated in FIG. 14 is described in the sixth embodiment, for example, the first to fourth inductive elements 25 to 28 in the polyphase filter 5 may be connected like the first to fourth inductive elements 31 to 32 illustrated in FIG. 9.

### Seventh Embodiment

In a seventh embodiment, an exemplary case where a plurality of loads included in a load group 6 is inductive elements 61-1 to 61-4 and the inductive elements 61-1 to 61-4 also serve as inductive elements included in a polyphase filter 5 will be described.

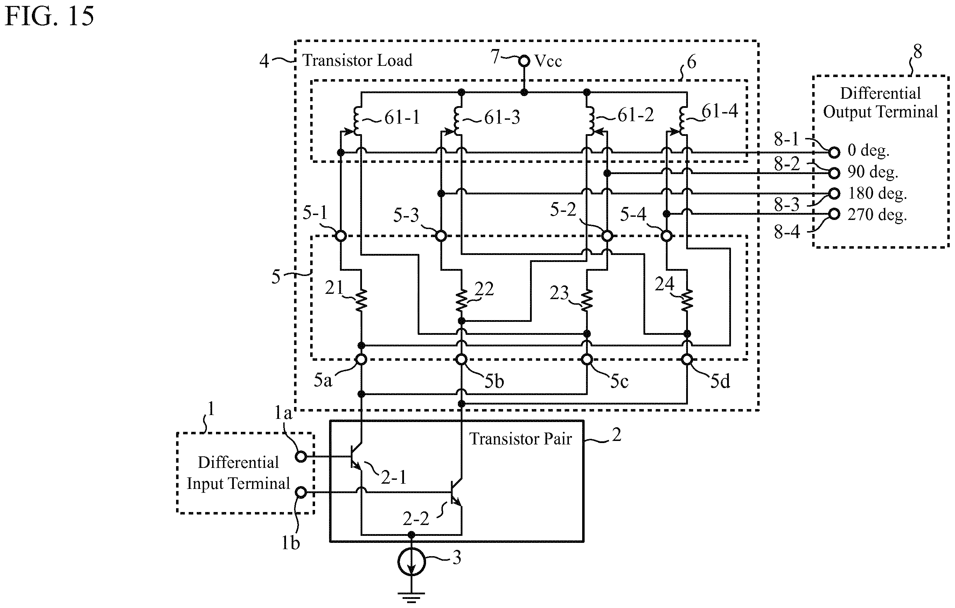

FIG. 15 is a configuration diagram illustrating a high frequency amplifier according to the seventh embodiment of the present invention.

In FIG. 15, the reference signs same as those in FIGS. 1 and 14 indicate the same or corresponding parts, and thus descriptions thereof will be omitted.

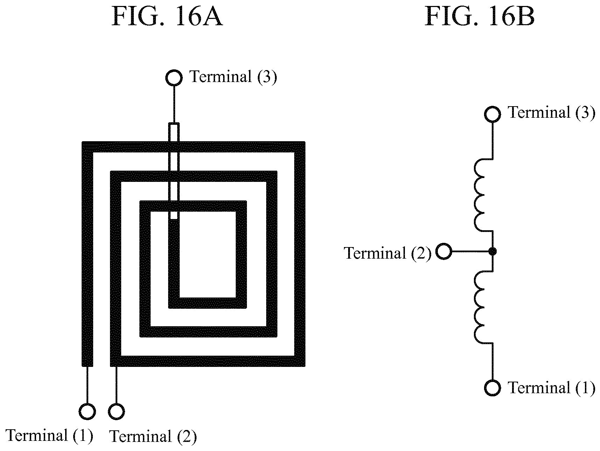

FIG. 16 is an explanatory diagram illustrating the inductive elements 61-1 to 61-4.

FIG. 16A illustrates an exemplary layout of the inductive elements 61-1 to 61-4, and FIG. 16B illustrates an equivalent circuit of the inductive elements 61-1 to 61-4.

The inductive element 61-1 serves as the inductive element 6-5 illustrated in FIG. 14 and the first inductive element 25 illustrated in FIG. 14.

In the inductive element 61-1, a terminal (1) is connected to a third input terminal 5c of a polyphase filter 5, a terminal (2) is connected to a first output terminal 5-1 of the polyphase filter 5, and a terminal (3) is connected to a power supply 7.

The inductive element 61-2 serves as the inductive element 6-6 illustrated in FIG. 14 and the second inductive element 26 illustrated in FIG. 14.

In the inductive element 61-2, a terminal (1) is connected to a second input terminal 5b of the polyphase filter 5, a terminal (2) is connected to a second output terminal 5-2 of the polyphase filter 5, and a terminal (3) is connected to the power supply 7.

The inductive element 61-3 serves as the inductive element 6-7 illustrated in FIG. 14 and the third inductive element 27 illustrated in FIG. 14.

In the inductive element 61-3, a terminal (1) is connected to a fourth input terminal 5d of the polyphase filter 5, a terminal (2) is connected to a third output terminal 5-3 of the polyphase filter 5, and a terminal (3) is connected to the power supply 7.

The inductive element 61-4 serves as the inductive element 6-8 illustrated in FIG. 14 and the fourth inductive element 28 illustrated in FIG. 14.

In the inductive element 61-4, a terminal (1) is connected to a first input terminal 5a of the polyphase filter 5, a terminal (2) is connected to a fourth output terminal 5-4 of the polyphase filter 5, and a terminal (3) is connected to the power supply 7.

While operation of the high frequency amplifier according to the seventh embodiment is similar to the operation of the high frequency amplifier according to the sixth embodiment, the inductive elements 61-1 to 61-4 included in the load group 6 also serve as the inductive elements included in the polyphase filter 5, whereby the number of parts can be reduced compared to the sixth embodiment.

Note that, in the present invention, the respective embodiments can be freely combined, any constituent element of each embodiment can be modified, and any constituent element of each embodiment can be omitted within the scope of the invention.

### INDUSTRIAL APPLICABILITY

The present invention is suitable for a high frequency amplifier that amplifies first and second signals that are differential signals.

### REFERENCE SIGNS LIST

1: Differential input terminal, 1a: First signal input terminal, 1b: Second signal input terminal, 2: Transistor pair, 2-1: First transistor, 2-2: Second transistor, 2-3: Third transistor, 2-4: Fourth transistor, 2-1a, 2-2a, 2-3a, 2-4a: Parasitic capacitance, 3, 9: Current source, 4: Transistor load, 5: Polyphase filter, 5a: First input terminal, 5b: Second input terminal, 5c: Third input terminal, 5d: Fourth input terminal, 5-1: First output terminal, 5-2: Second output terminal, 5-3: Third output terminal, 5-4: Fourth output terminal, 6: Load group, 6a, 6b, 6-1 to 6-4: Load, 6-5 to 6-8: Inductive element, 7: Power supply, 8: Differential output terminal, 8a, 8b, 8-1 to 8-4: Amplifier output terminal, 11 to 14: Resistor, 15 to 18: Capacitive element, 21: First resistor, 22: Second resistor, 23: Third resistor, 24: Fourth resistor, 25: First inductive element, 26: Second inductive element, 27: Third inductive element, 28: Fourth inductive element, 31: First inductive element, 32: Second inductive element, 33: Third inductive element, 34: Fourth inductive element, 41: First series circuit, 42: Capacitive element, 43: Resistor, 44: Second series circuit, 45: Capacitive element, 46: Resistor, 51: Capacitive element (First matching circuit), 52: Capacitive element (Second matching circuit), 53: Capacitive element (Third matching circuit), 54: Capacitive element (Fourth matching circuit), 61-1 to 61-4: Inductive element.

## Claims

1. A high frequency amplifier, comprising:
a first transistor for amplifying a first signal;
a second transistor for amplifying a second signal that is a differential signal with respect to the first signal;
a polyphase filter that includes a first input terminal connected to an output terminal of the first transistor, a second input terminal connected to an output terminal of the second transistor, and first to fourth output terminals, generates a first differential signal from the first signal amplified by the first transistor and outputs the first differential signal from the first and third output terminals, and generates a second differential signal from the second signal amplified by the second transistor and outputs the second differential signal from the first and third output terminals;
a plurality of loads having one end connected to each of the first and third output terminals of the polyphase filter and another end connected a power supply; and
a plurality of amplifier output terminals connected to each of the first and third output terminals of the polyphase filter.

2. The high frequency amplifier according to claim 1, wherein
the polyphase filter generates, from the first signal amplified by the first transistor, a third differential signal having a phase shifted by 90 degrees from a phase of the first differential signal and outputs the third differential signal from the second and fourth output terminals, and generates, from the second signal amplified by the second transistor, a fourth differential signal having a phase shifted by 90 degrees from a phase of the second differential signal and outputs the fourth differential signal from the second and fourth output terminals,
the plurality of loads has one ends connected to each of the first to fourth output terminals of the polyphase filter and other ends connected to the power supply, and
the plurality of amplifier output terminals are connected to each of the first to fourth output terminals of the polyphase filter.

3. The high frequency amplifier according to claim 2, wherein
the polyphase filter includes:
a first resistor having one end connected to the first input terminal and another end connected to the first output terminal;
a second resistor having one end connected to the second input terminal and another end connected to the third output terminal;
a first inductive element having one end connected to the first output terminal;
a second inductive element having one end connected to the second input terminal and another end connected to the second output terminal;
a third resistor having one end connected to another end of the first inductive element and another end connected to the second output terminal;
a third inductive element having one end connected to the third output terminal;
a fourth resistor having one end connected to another end of the third inductive element and another end connected to the fourth output terminal; and
a fourth inductive element having one end connected to the first input terminal and another end connected to the fourth output terminal.

4. The high frequency amplifier according to claim 3, further comprising:
a third transistor for amplifying the first signal to be amplified by the first transistor; and
a fourth transistor for amplifying the second signal to be amplified by the second transistor, wherein
an output terminal of the third transistor is connected to a third input terminal of the polyphase filter,
an output terminal of the fourth transistor is connected to a fourth input terminal of the polyphase filter,
the third input terminal of the polyphase filter is connected to one end of the third resistor, and
the fourth input terminal of the polyphase filter is connected to one end of the fourth resistor.

5. The high frequency amplifier according to claim 4, wherein
the first inductive element has inductive reactance that cancels out parasitic capacitance of the third transistor,
the second inductive element has inductive reactance that cancels out parasitic capacitance of the second transistor,
the third inductive element has inductive reactance that cancels out parasitic capacitance of the fourth transistor, and
the fourth inductive element has inductive reactance that cancels out parasitic capacitance of the first transistor.

6. The high frequency amplifier according to claim 3, further comprising:
a third transistor having an output terminal to be connected to a third input terminal of the polyphase filter; and
a fourth transistor having an output terminal to be connected to a fourth input terminal of the polyphase filter, wherein
one end of a first series circuit in which a capacitive element and a resistor are connected in series is connected to a control terminal of the third transistor,
one end of a second series circuit in which a capacitive element and a resistor are connected in series is connected to a control terminal of the fourth transistor,
each of other ends of the first and second series circuits is connected to ground,
the third input terminal of the polyphase filter is connected to one end of the third resistor, and
the fourth input terminal of the polyphase filter is connected to one end of the fourth resistor.

7. The high frequency amplifier according to claim 6, wherein
the first inductive element has inductive reactance that cancels out parasitic capacitance of the third transistor,
the second inductive element has inductive reactance that cancels out parasitic capacitance of the second transistor,
the third inductive element has inductive reactance that cancels out parasitic capacitance of the fourth transistor, and
the fourth inductive element has inductive reactance that cancels out parasitic capacitance of the first transistor.

8. The high frequency amplifier according to claim 6, further comprising:
first to fourth matching circuits for matching impedance between each of the first to fourth transistors and the polyphase filter.

9. The high frequency amplifier according to claim 1, wherein
each of the plurality of loads is an inductive element.

10. The high frequency amplifier according to claim 3, wherein
each of the plurality of loads is an inductive element, and
each of the inductive elements also serves as the first to fourth inductive elements included in the polyphase filter.

11. The high frequency amplifier according to claim 2, wherein
the polyphase filter includes:
a first resistor having one end connected to the first input terminal and another end connected to the first output terminal;
a second resistor having one end connected to the second input terminal and another end connected to the third output terminal;
a first inductive element having one end connected to the first input terminal and another end connected to the second output terminal;
a second inductive element having one end connected to the third output terminal;
a third resistor having one end connected to another end of the second inductive element and another end connected to the second output terminal;
a third inductive element having one end connected to the second input terminal and another end connected to the fourth output terminal;
a fourth inductive element having one end connected to the first output terminal; and
a fourth resistor having one end connected to another end of the fourth inductive element and another end connected to the fourth output terminal.
